# DEMANDE DE BREVET EUROPEEN

(11) **EP 1 981 136 A2**
(43) Date de publication de la demande: **15.10.2008**
(21) Numéro de dépôt: 08158430.2
(22) Date de dépôt: 04.10.1999
(51) Int. Cl.: H01S 5/06, H01S 5/34

(54) **Laser à semiconducteur, à spectre de gain accordable**

(30) Priorité: 07.10.1998 FR 9812558
(62) Demande divisionnaire de: 99402425.5
(71) Demandeur: Xantima LLC, Las Vegas, NV 89119 (US)
(72) Inventeur: Pelekanos, Nikolaos, 38000, Grenoble (FR); Ortiz, Valentin, 38000, Grenoble (FR); Mula, Guido, 38100, Grenoble (FR)
(74) Mandataire: Viering, Jentschura & Partner

(57) **Abrégé**

Ce laser comprend une zone active comprenant au moins un puits quantique actif (AQW) qui émet un rayonnement laser lors de l'introduction de porteurs dans la zone active et au moins un puits quantique de collection (CQW₁, CQW₂), de chaque côté du puits actif, pour collecter et confiner une partie des porteurs introduits. Des moyens de répartition des porteurs dans les puits de collection sont prévus pour créer un champ de charge d'espace pour modifier, pendant l'émission du rayonnement et par un effet électro-optique, le spectre de gain de ce puits actif. Application aux télécommunications optiques.

## Description

### DOMAINE TECHNIQUE

La présente invention concerne un laser à semiconducteur, à spectre de gain accordable.

L'invention est utilisable en tant que source laser accordable en fréquence ou en tant que dispositif à commutation de gain optique et trouve des applications dans divers domaines tels que par exemple les télécommunications optiques, les lidars et la spectroscopie.

Le mot « laser » est employé ici au sens large en tant qu'amplificateur de lumière avec ou sans cavité.

### ÉTAT DE LA TECHNIQUE ANTÉRIEURE

On connaît déjà des diodes lasers accordables par variation de température, par le document [1] qui, comme les autres documents cités par la suite, est mentionné à la fin de la présente description. De telles diodes ont un temps de réponse de l'ordre de 1 seconde.

On connaît également par le document [2] des diodes lasers accordables au moyen d'un réseau de diffraction externe. De telles diodes ont un temps de réponse de l'ordre 1 milliseconde et sont de plus massives et très coûteuses.

On connaît en outre par le document [3] des diodes lasers accordables comprenant une région active, une région à indice de réfraction variable et une région formant un réflecteur de Bragg réparti, régions qui sont intégrées de façon monolithique sur un substrat. De telles diodes ont un temps de réponse de l'ordre de 1 nanoseconde mais sont difficiles à fabriquer et donc coûteuses et nécessitent de plus des moyens électroniques complexes pour commander la longueur d'onde du rayonnement laser émis car trois courants électriques sont nécessaires à cet effet (un courant pour chacune des régions mentionnées plus haut).

De plus, le document [4] divulgue la possibilité de moduler le spectre de gain pendant une émission laser par l'intermédiaire de l'effet Stark confiné quantique (« quantum confined Stark effect »). Dans le dispositif laser décrit dans ce document, une zone active à puits quantique est formée dans la zone intrinsèque d'une jonction P-I-N polarisée en inverse et le gain dans le puits quantique est obtenu de façon optique. De ce fait, un tel dispositif laser n'est pas du tout commode.

### EXPOSÉ DE L'INVENTION

La présente invention a pour but de remédier aux inconvénients précédents en proposant une diode laser accordable en longueur d'onde, à émission par la tranche (« edge emission »), qui est plus simple à fabriquer et donc moins coûteuse que les diodes lasers connues par le document [3] (elle ne nécessite qu'un seul courant de commande), tout en étant rapide, son temps de réponse, c'est-à-dire son temps de commutation de longueur d'onde, étant de l'ordre de 1 nanoseconde ou moins.

Le principe de l'accord de cette diode laser est fondé sur une modulation, par un effet électro-optique tel que l'effet Stark confiné quantique, du spectre de gain de la diode pendant l'émission du rayonnement laser. La zone active de cette diode laser est conçue de façon appropriée pour que l'unique courant injecté engendre simultanément un gain dans la couche active et un champ de charge d'espace qui permet la modulation de la longueur d'onde du rayonnement laser.

Dans tous les modes de réalisation préférés de l'invention, cette longueur d'onde est directement commandée par le courant injecté dans la diode laser. Toutefois, dans certains modes de réalisation particuliers, cette longueur d'onde peut être commandée par un faisceau laser auxiliaire.

Dans d'autres modes de réalisation particuliers, le laser objet de l'invention peut même fonctionner de façon totalement optique. Dans ce cas, soit le gain et la modulation de longueur d'onde sont créés par un faisceau laser de pompe soit le gain est créé par un faisceau laser de pompe et la modulation de longueur d'onde par un faisceau laser auxiliaire.

De façon plus générale, l'invention propose un laser accordable dont on peut modifier la longueur d'onde très rapidement, avec un temps de commutation très court de l'ordre de 1 ns ou moins.

De façon précise, la présente invention a pour objet un laser accordable comprenant une hétérostructure semiconductrice, ce laser étant caractérisé en ce que l'hétérostructure comprend une zone active comprenant au moins un puits quantique appelé puits quantique actif et destiné à émettre un rayonnement laser lors de l'introduction de porteurs de charge dans la zone active et au moins un autre puits quantique, appelé puits quantique de collection, de chaque côté du puits quantique actif, les puits quantiques de collection étant prévus pour collecter et confiner une partie des porteurs de charge introduits, et des moyens de répartition des porteurs de charge dans les puits quantiques de collection de manière à créer un champ de charge d'espace prévu pour agir sur le puits quantique actif pendant l'émission du rayonnement laser en modifiant, par un effet électro-optique, le spectre de gain de ce puits quantique actif.

Une variation du nombre de porteurs de charge introduits est ainsi apte à modifier ce champ de charge d'espace et donc la longueur d'onde du rayonnement laser.

De préférence, la transition optique la plus basse de chacun des puits quantiques de collection est à une énergie supérieure à celle du puits quantique actif.

De préférence également, les états fondamentaux des bandes de valence et de conduction de l'hétérostructure sont dans le puits quantique actif.

Selon un premier mode de réalisation particulier du laser objet de l'invention, ce laser forme une diode laser, l'hétérostructure formant une jonction P-I-N destinée à être polarisée de façon directe et comportant une zone intrinsèque comprise entre une zone de type P et une zone de type N, la zone active étant formée dans cette zone intrinsèque, le rayonnement laser étant émis lors de l'injection d'un courant des porteurs de charge dans la zone active.

Dans ce cas, les moyens de répartition des porteurs de charge peuvent comprendre des moyens de polarisation directe de la jonction P-I-N, l'inhonomogénéité du courant d'injection dans la zone active étant responsable de la séparation des porteurs de charge.

Selon un deuxième mode de réalisation particulier, les moyens de répartition des porteurs de charge comprennent deux barrières piézoélectriques qui sont respectivement placées de part et d'autre du puits quantique actif et, qui par l'intermédiaire de leurs champs piézoélectriques provoquent une accumulation d'électrons et de trous de part et d'autre du puits quantique actif.

Dans ce deuxième mode de réalisation particulier, le puits quantique actif peut ne pas avoir de champ piézoélectrique ou peut avoir un champ piézoélectrique de sens contraire à celui qui est créé par les barrières piézoélectriques ou peut avoir un champ piézoélectrique de même sens que celui qui est créé par ces barrières piézoélectriques.

De plus, dans ce deuxième mode de réalisation particulier, les puits quantiques de collection peuvent être conçus pour que les temps mis par les porteurs de charge pour s'échapper de ces puits quantiques de collection soient de l'ordre de 1 nanoseconde.

Selon un troisième mode de réalisation particulier de la diode laser objet de l'invention, la zone active comprend au moins deux barrières piézoélectriques et au moins deux puits quantiques de collection de chaque côté du puits quantique actif, les moyens de répartition des porteurs de charges comprenant ces barrières piézoélectriques.

Dans ce cas, la largeur de bande interdite de chacun des puits quantiques de collection, qui sont respectivement les plus loins du puits quantique actif est de préférence supérieure à celles de chacun des autres puits quantiques de collection, de manière à ce que les porteurs puissent traverser par effet tunnel.

Dans le cas des deuxième et troisième modes de réalisation particuliers, le nombre de porteurs de charge introduits peut être maintenu constant, la longueur d'onde du rayonnement laser étant alors commandée par un faisceau laser auxiliaire dont les photons ont une énergie supérieure à la largeur de bande interdite de chaque barrière piézoélectrique et dont l'intensité est suffisamment élevée pour induire optiquement une charge de l'hétérostructure.

Dans ce cas, les porteurs de charge peuvent être introduits au moyen d'un faisceau laser prévu pour pomper la zone active. De plus, ce faisceau laser prévu pour pomper la zone active peut être également prévu pour constituer le faisceau laser auxiliaire (afin de commander aussi la longueur d'onde).

Comme on l'a vu plus haut, dans certains modes de réalisation particuliers de l'invention, la séparation de porteurs de charge de part et d'autre du puits quantique actif résulte de l'introduction de couches piézoélectriques dans la zone active du laser. Pour des semiconducteurs cristallins de type zincblende, ces couches piézoélectriques sont de préférence des couches contraintes que l'on fait croître par épitaxie sur la surface du substrat de l'hétérostructure, ce substrat ayant des indices cristallographiques (n, 1, m) élevés, avec nxlxm≠0, comme par exemple un substrat (111) ou (211).

À ce sujet on se reportera par exemple au document [5] qui montre que la contrainte biaxiale présente dans de telles couches engendre dans celles-ci un fort champ piézoélectrique le long de l'axe de croissance.

Dans ces semiconducteurs de type zincblende les champs piézoélectriques peuvent facilement atteindre des valeurs supérieures à 100 kV/cm pour des contraintes relativement modérées de désadaptation de réseaux cristallins de l'ordre de ε=0,7%. A ce sujet on pourra se reporter au document [6].

Dans la présente invention, en tant qu'effet électro-optique, on utilise de préférence l'effet Stark confiné quantique. Mais d'autres effets, comme par exemple l'effet Franz-Keldysh ou l'effet Wannier-Stark sont aussi utilisables.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 illustre schématiquement un premier mode de réalisation particulier du laser objet de l'invention,
- la figure 2 illustre schématiquement un deuxième mode de réalisation particulier, comprenant des barrières piézoélectriques, et
- la figure 3 illustre schématiquement un troisième mode de réalisation particulier comprenant aussi des barrières piézoélectriques.

### EXPOSÉ DÉTAILLÉ DE MODES DE RÉALISATION PARTICULIERS

Une diode laser conforme à l'invention est formée sur une couche semiconductrice (substrat semiconducteur ou couche-tampon, par exemple en GaN, sur un substrat par exemple en saphire) et comprend une zone active formée dans la zone intrinsèque I d'une jonction P-I-N que l'on polarise de façon directe pour faire fonctionner la diode laser.

De l'un et l'autre côté de la zone active il existe une ou plusieurs couches de confinement qui sont prévues pour confiner le rayonnement laser engendré dans la zone active et qui peuvent être dopées (du type N lorsqu'elles sont du côté de la zone N de la jonction et du type P lorsqu'elles sont du côté de la zone P de cette jonction) afin de faciliter l'injection de courant dans cette jonction.

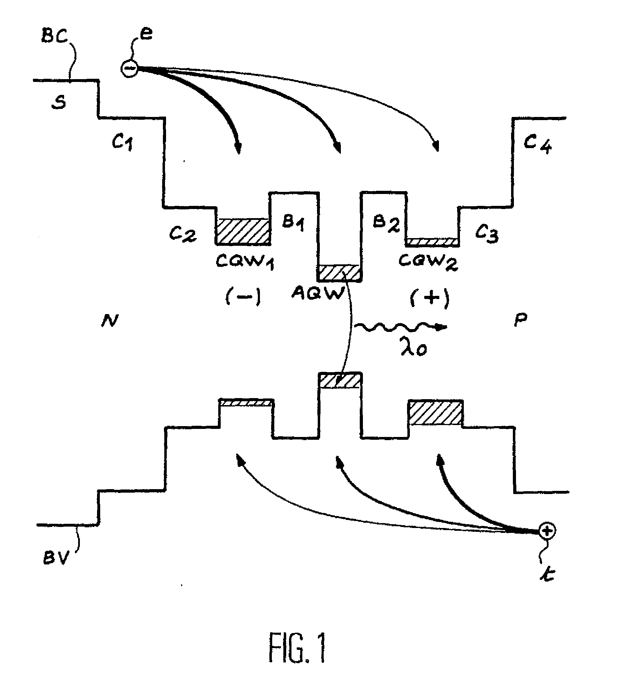

La figure 1 illustre schématiquement un exemple de la zone active d'une diode laser conforme à l'invention sous la forme d'un diagramme de bandes, la bande de valence étant notée BV et la, bande de conduction BC.

En allant de la gauche à la droite de cette figure, on trouve successivement une première couche semiconductrice S qui pourrait être le substrat, une première couche de confinement inférieure C₁, une deuxième couche de confinement inférieure C₂, une couche de puits quantique de collection CQW₁, une couche de barrière B₁, une couche de puits quantique actif AQW, une autre couche de barrière B₂, une autre couche de puits quantique de collection CQW₂, une première couche de confinement supérieure C₃ et une deuxième couche de confinement supérieure C₄. Les couches conductrices (électrodes) permettant de polariser la diode de façon directe ne sont pas représentées.

Au centre de la zone active il y a, dans une diode conforme à l'invention, au moins un puits quantique actif qui est le puits quantique dont la transition optique la plus basse est destinée à émettre un rayonnement laser et à être modulée. Dans les exemples donnés, pour des raisons de clarté, on a seulement décrit des hétérostructures avec un seul puits quantique actif mais, dans d'autres exemples, ce puits pourrait être remplacé par deux ou plus de deux puits quantiques actifs.

Dans l'exemple représenté sur la figure 1, il existe un puits quantique de collection de chaque côté du puits quantique actif mais on pourrait prévoir deux ou plus de deux puits quantiques de collection de chaque côté de ce puits quantique actif.

Chaque puits quantique de collection est conçu pour que la transition optique la plus basse de ce puits soit à une énergie supérieure à celle du puits quantique actif afin de ne pas gêner l'émission laser du puits quantique actif par une absorption inutile.

La fonction des puits quantiques de collection est de collecter et de confiner les porteurs de charge (électrons et trous) - plus simplement appelés porteurs dans ce qui suit - qui sont séparés par un mécanisme que l'on verra par la suite pour différents modes de réalisation particuliers. Ces porteurs séparés créent un champ de charge d'espace et donc une modulation de longueur d'onde du rayonnement laser émis.

On fait maintenant des considérations qui s'appliquent à tous les modes de réalisation particuliers de l'invention qui sont décrits en faisant référence aux dessins.

Si l'on considère une hétérostructure du genre de celle de la figure 1 pour laquelle l'effet laser du puits quantique actif se produit pour une densité de courant donnée I₀, cette hétérostructure est conçue pour la modulation, de préférence par effet Stark confiné quantique, du spectre de gain laser lorsque la densité de courant injecté varie dans un intervalle autour de I₀.

Pour ce faire, l'hétérostructure doit d'abord être capable, sous ces conditions d'excitation, d'accumuler dans les puits quantiques de collection une densité de charge suffisante pour produire un' champ de charge d'espace élevé. Par exemple, pour avoir un champ de charge d'espace de 100 kV/cm, on a besoin d'une densité de charge de 6x10¹¹ cm⁻² dans les puits quantiques de collection (en négligeant les effets d'écran) .

Simultanément, le mécanisme de séparation des charges doit être à un régime non saturé c'est-à-dire à un régime où une variation de la densité du courant injecté provoque une variation des densités de charge des puits quantiques de collection et donc une variation de la modulation de longueur d'onde.

L'accumulation de charges dans les puits quantiques de collection dépend
(a) du mécanisme de séparation des charges et
(b) des temps d'échappement des porteurs collectés dans les puits quantiques de collection.

En résolvant de simples équations de taux décrivant la dynamique des porteurs dans une structure du genre de celle de la figure 1 et en utilisant le mécanisme de séparation de charges dont il sera question dans la description du deuxième mode de réalisation préféré (donnée plus loin) on peut obtenir l'ordre de grandeur des temps d'échappement nécessaires pour avoir un effet de modulation important pour une densité donnée de courant injecté I₀.

Par exemple si I₀ est égal à 1 kA/cm² les temps qu'il faut aux porteurs pour s'échapper des puits quantiques de collection doivent être de l'ordre de 1 ns pour obtenir un champ de charge d'espace de 50 kV/cm. Si, dans l'exemple donné, les temps d'échappement sont bien inférieurs à 1 ns, les calculs montrent qu'il n'y a pas suffisamment d'accumulation de charges dans les puits quantiques de collection et que le champ de modulation est faible.

Par ailleurs si les temps d'échappement sont beaucoup plus longs on peut avoir une suraccumulation de charges et un champ de charge d'espace élevé qui peut nuire à l'effet laser du puits quantique actif (en effet un champ électrique décale et réduit le spectre de gain et donc un champ électrique trop grand nuit à l'effet laser) ou être à un régime où le processus de séparation des charges atteint une saturation.

Ainsi une « conception » appropriée des temps d'échappement des porteurs est essentielle pour le bon fonctionnement de la diode laser. Une telle conception est possible en considérant que les principaux processus d'échappement des porteurs des puits quantiques de collection sont l'émission thermoionique par dessus les barrières et l'effet tunnel à travers ces barrières.

En choisissant convenablement les paramètres de l'hétérostructure qui influencent fortement ces processus, tels que par exemple les hauteurs et les épaisseurs des barrières, on est capable de modifier les taux d'échappement des porteurs de plusieurs ordres de grandeur.

En outre les temps d'échappement des porteurs des puits quantiques de collection commandent au moins en partie la vitesse de commutation de longueur d'onde de la diode laser. Supposons que cette diode laser soit commandée par une densité de courant I₀ et que la densité de charge des puits quantiques de collection correspondante soit Q₀.

Un accroissement soudain de I₀ est suivi par un accroissement rapide de Q₀ et les temps typiques de montée (« switch-up ») nécessaires pour établir le nouvel équilibre sont essentiellement les temps de relaxation des porteurs chauds qui sont de l'ordre de quelques dizaines de picosecondes.

Par ailleurs une décroissance soudaine de I₀ entraîne une décroissance de Q₀ mais avec des temps de descente (« switch down ») plus longs, définis par les temps d'échappement des porteurs des puits quantiques de collection.

Comme on l'a mentionné plus haut, les temps d'échappement souhaités peuvent être facilement obtenus par une conception appropriée de l'hétérostructure et, pour des conceptions réalistes, peuvent être dans un domaine allant de 100 ps à 1 ns à titre d'exemple, mais pourraient être dans un autre domaine.

De plus, afin que le puits quantique actif émette un rayonnement laser pour des densités de courant raisonnables, on doit faire en sorte
(a) qu'une grande partie des porteurs injectés soient collectés dans le puits quantique actif et
(b) que les porteurs collectés restent dans le puits quantique actif pendant des temps suffisamment longs.

Une façon de remplir la condition (a) est de faire en sorte que les états fondamentaux des bandes de valence BV et de conduction BC de l'hétérostructure soient tous deux dans le puits quantique actif.

Pour remplir la condition (b) les temps d'échappement des porteurs du puits quantique actif doivent être bien plus grands que les temps de recombinaison radiative ou d'émission stimulée.

On considère maintenant un premier mode de réalisation préféré de la diode laser objet de l'invention.

Ce premier mode de réalisation est celui qui est schématiquement illustré par la figure 1 et a déjà été décrit. Son principe de fonctionnement est expliqué ci-après.

La zone active est dans la jonction P-I-N. Des moyens de polarisation directe de cette jonction permettent d'injecter dans la zone active des électrons e provenant de la zone N et des trous t provenant de la zone P.

Du fait que la couche CQW₁ est proche de la zone N, le nombre des électrons injectés, qui sont collectés par cette couche CQW₁, est supérieur au nombre de ceux qui sont collectés par la couche AQW et la couche CQW₂. De même, du fait que cette couche CQW₂ est proche de la zone P, le nombre des trous injectés, qui sont collectés par cette couche CQW₂, est supérieur au nombre de ceux qui sont collectés par la couche AQW et la couche CQW₁.

Il en résulte qu'à des niveaux de courant d'injection capables d'induire l'effet laser dans la couche AQW il y a un surplus d'électrons dans la couche CQW₁ (ce que l'on a symbolisé par le signe (-) sur la figure 1) et un surplus de trous dans la couche CQW₂ (symbolisé par le signe (+) sur la figure 1).

Ceci se traduit par un champ de charge d'espace qui module, de préférence par l'intermédiaire de l'effet Stark confiné quantique, la transition électronique d'émission laser de la couche AQW.

Comme on l'a vu plus haut, la modulation consiste en un décalage de la longueur d'onde du rayonnement laser ainsi qu'en une variation de gain.

Si le courant d'injection est davantage augmenté le champ de charge d'espace augmente aussi et il en est de même pour la modulation. On obtient ainsi l'accord de la longueur d'onde λ₀ du rayonnement laser de la diode laser.

Ce mécanisme de séparation ou répartition des charges dépend de façon critique de l'inhomogénéité du courant d'injection dans la zone active. On peut influencer l'efficacité de séparation des charges en réglant en conséquence les paramètres de l'hétérostructure. Par exemple, si l'on augmente la distance entre chaque puits quantique de collection et le puits quantique actif, la séparation des charges est plus efficace.

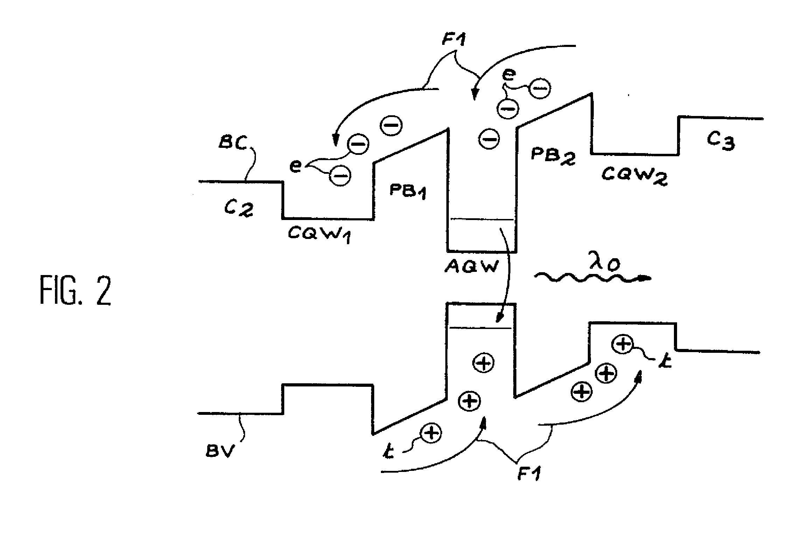

On considère maintenant un deuxième mode de réalisation préféré de la diode laser objet de l'invention qui est schématiquement illustré par la figure 2.

L'hétérostructure de la figure 2 est identique à celle de la figure 1 excepté que les couches de barrière B₁ et B₂ de la figure 1 sont, dans le cas de la figure 2, des couches de barrière piézoélectriques notées PB₁ et PB₂. La couche semiconductrice S, la couche C₁ et la couche C₄ ne sont pas représentées sur la figure 2.

Dans ce deuxième mode de réalisation préféré, l'élément essentiel pour le processus de séparation ou répartition des charges est constitué par les barrières piézoélectriques disposées entre la couche AQW et les couches CQW₁ et CQW₂.

Pour des semiconducteurs cristallins de type zincblende, on fait croître l'hétérostructure sur une couche semiconductrice ayant des indices cristallographiques (n, 1, m) élévés, avec nxlxm≠0.

On précise que les autres couches de la zone active peuvent également avoir un champ piézoélectrique.

Ce deuxième mode de réalisation est un perfectionnement du premier en ce que l'inhomogénéité de courant d'injection dans la zone active n'est plus une condition nécessaire pour accomplir une séparation utile des charges.

Le mécanisme de séparation des charges dans ce deuxième mode de réalisation est expliqué ci-après.

Une fraction des électrons et des trous injectés sont séparés de l'un et l'autre côté de chaque couche de barrière piézoélectrique par l'action du champ piézoélectrique. Les électrons et les trous collectés dans la couche AQW participent directement à l'action d'émission du rayonnement laser de cette couche AQW et le résultat de la présence de couches de barrière piézoélectriques est une accumulation d'électrons dans la couche CQW₁ et de trous dans la couche CQW₂. Le champ de charge d'espace qui en résulte module alors la transition laser de la couche AQW.

Si la couche AQW n'a pas de champ piézoélectrique (cas de la figure 2) ou un champ piézoélectrique qui s'oppose à celui des barrières piézoélectriques alors le champ de charge d'espace entraîne un décalage vers les grandes longueurs d'onde de la transition de la couche AQW.

Par ailleurs si la couche AQW a un champ piézoélectrique ayant le même sens que celui des couches des barrières piézoélectriques alors le champ de charge d'espace entraîne un décalage vers les courtes longueurs d'onde de cette transition laser.

Il est possible de commander le champ piézoélectrique de la couche AQW en réglant simplement l'état de contrainte de cette couche. Donc, suivant les besoins d'applications spécifiques, il est possible de concevoir une diode laser qui est accordable par effet Stark confiné quantique de préférence et dont la longueur d'onde émise est décalée soit vers les grandes longueurs d'onde soit vers les courtes longueurs d'onde.

L'hétérostructure à barrières piézoélectriques de la figure 2 présente des points communs avec le modulateur de lumière commandé optiquement dont il est question dans les documents [7] et [8].

Il existe cependant des différences claires entre le modulateur et la diode du fait des fonctions différentes de ceux-ci.

Dans le modulateur, les temps d'échappement des puits quantiques de collection sont de l'ordre de 1 µs afin de limiter, pour des raisons pratiques, la densité de puissance du faisceau optique de commande à quelques watts par centimètre carré. En conséquence les puits quantique de collection sont rendus relativement profonds pour réduire les taux d'échappement par émission thermoionique et les barrières piézoélectriques sont rendues relativement épaisses pour leur éviter de se vider rapidement par effet tunnel à travers ces barrières.

Par ailleurs, dans la présente invention, les temps d'échappement des porteurs des puits quantiques de collection sont de l'ordre de 1 ns afin d'avoir un effet de modulation pour des densités de courant de l'ordre de 1 kA/cm², densité auquel l'effet laser se produit le plus vraisemblablement. En conséquence, les puits quantiques de collection sont rendus relativement moins profonds et les barrières piézoélectriques relativement moins épaisses.

Un autre aspect de conception qui est crucial pour la diode laser accordable et sans importance pour le modulateur est indiqué dans ce qui suit.

Pour que le puits quantique actif émette un rayonnement laser pour des densités de courant raisonnables il est souhaitable qu'une grande majorité des porteurs injectés soit collectée dans le puits quantique actif et y demeure pendant des temps suffisamment longs pour participer à l'émission laser. Une manière d'obtenir cela est de faire en sorte que les états fondamentaux des bandes de valence et de conduction de l'hétérostructure soient dans la couche de puits quantique actif.

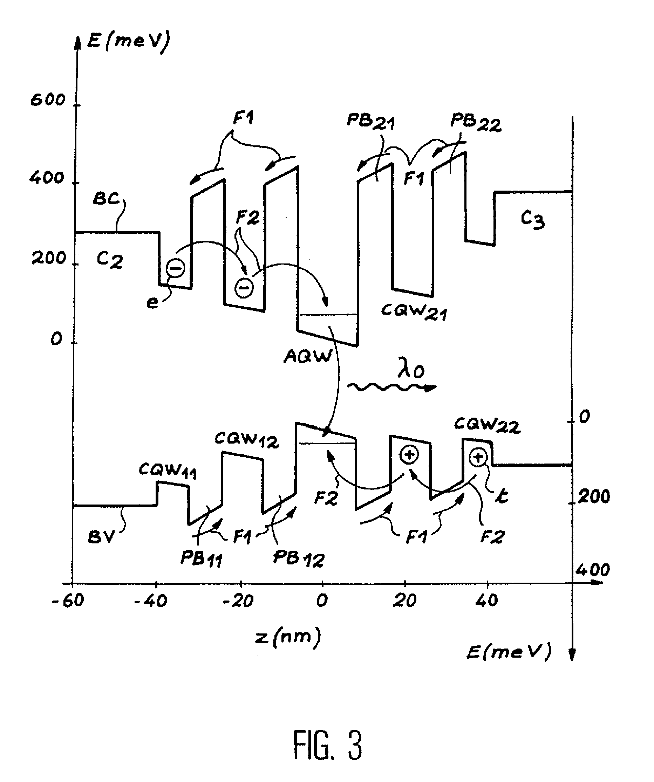

Le troisième mode de réalisation préféré de l'invention, qui est schématiquement illustré par la figure 3, est essentiellement un prolongement du deuxième et a le même principe de fonctionnement.

La différence entre les hétérostructures des figures 2 et 3 réside dans le fait que celle de la figure 3 contient plus d'une barrière piézoélectrique et plus d'un puits quantique de collection de l'un et l'autre côté du puits quantique actif.

Dans l'exemple de la figure 3 on trouve successivement, de gauche à droite, la couche de confinement C₂, une couche de puits quantique de collection CQW₁₁, une couche de barrière piézoélectrique PB₁₁, une autre couche de puits quantique de collection CQW₁₂, une autre couche de barrière piézoélectrique PB₁₂, la couche de puits quantique actif AQW puis une couche de barrière piézoélectrique PB₂₁, une couche de puits quantique de collection CQW₂₁, une autre couche de barrière piézoélectrique PB₂₂, une autre couche de puits quantique de collection CQW₂₂ et la couche de confinement C₃. Le substrat et les autres couches de confinement ne sont pas représentés.

A titre purement indicatif et nullement limitatif on a également indiqué sur la figure 3 des exemples de valeurs numériques pour les épaisseurs z des différentes couches (exprimées en nanomètres), en prenant l'origine de l'axe z au milieu de la couche AQW, ainsi que pour les énergies E relatives à la bande de valence et à la bande de conduction de l'hétérostructure (exprimées en meV).

On précise que les flèches F1 de la figure 2 indiquent le processus de séparation des porteurs dans les barrières piézo électriques. Il en est de même pour la figure 3.

Les flèches F2 de cette figure 3 indiquent, quant à elles, le processus de transfert, par effet tunnel, des porteurs de charge, des puits de collection au puits actif.

L'amélioration résultant de l'hétérostructure de la figure 3 par rapport à celle de la figure 2 réside dans le fait que l'on réduit l'épaisseur de chaque couche de barrière piézoélectrique tout en conservant, pour l'ensemble des couches de barrières piézoélectriques, une épaisseur totale suffisamment grande pour avoir une séparation efficace des charges. De ce fait on augmente fortement la probabilité d'effet tunnel des porteurs des puits quantiques de collection.

Il est en effet préférable et plus simple de commander les temps d'échappement des porteurs des puits quantiques de collection par un processus indépendant de la température, à savoir l'effet tunnel, au lieu de les commander par un processus dépendant fortement de la température, à savoir l'émission thermoionique.

Ajoutons que dans le cas des figures 2 et 3, on a supposé l'introduction des porteurs de charge homogène dans la zone active. Ainsi, le côté, par rapport au puits actif, où s'accumulent les électrons dépend principalement du sens du champ piézo-électrique des barrières (côté gauche dans les exemples des figures 2 et 3). Donc, dans le cas d'une diode laser, il n'y a pas à spécifier le côté (N) où sont injectés les électrons ni le côté (P) où sont injectés les trous.

Les couches de barrières piézoélectriques et les couches de puits quantiques de collection de l'hétérostructure de la figure 3 peuvent être faites de semiconducteurs légèrement différents.

Dans l'exemple de la figure 3, la largeur de bande interdite des puits quantiques de collection CQW₁₁ et CQW₂₂ a été prise supérieure à celle des puits quantiques de collection CQW₁₂ et CQM₂₁ afin d'obtenir des conditions énergétiques favorables pour l'effet tunnel.

Comme on l'a vu plus haut, à part le cas où le spectre du rayonnement laser est commandé directement par le courant injecté dans la diode laser, on peut considérer des applications où il est intéressant de rendre ce courant constant et de commander la modulation de longueur λ₀ par un faisceau laser auxiliaire qui peut être pulsé ou continu. Ceci est possible pour des diodes construites selon l'enseignement des deuxième et troisième modes de réalisation particuliers.

Les conditions que ce faisceau laser auxiliaire doit remplir sont les suivantes :
(a) l'énergie des photons de ce faisceau auxiliaire doit être supérieure à la largeur de bande interdite des couches de barrières piézoélectriques et
(b) l'intensité de ce faisceau doit être suffisamment élevée pour induire optiquement les charges de l'hétérostructure.

On précise que ce faisceau laser auxiliaire est dirigé sur la zone active responsable de l'émission laser et absorbé par cette zone.

On donne maintenant des exemples d'hétérostructures.

Un aspect important de la présente invention est qu'elle peut être mise en oeuvre avec toute hétérostructure semiconductrice, en fonction (a) de l'application spécifique envisagée, (b) de la longueur d'onde souhaitée pour le rayonnement laser et (c) de la technique de fabrication dont on dispose.

On peut par exemple utiliser des semiconducteurs de type III-V ou II-VI, ayant des structures cristallines de type zincblende ou wurtzite. Pour les deuxième et troisième modes de réalisation, on peut faire croître les hétérostructures de type zincblende sur une couche semiconductrice, par exemple un substrat semiconducteur, dont les indices cristallographiques (n, 1, m) sont élevés, avec nxlxm≠0, alors qu'il suffit de faire croître les hétérostructures de type wurtzite par exemple le long de l'axe c du réseau cristallin de l'hétérostructure (c'est-à-dire l'axe qui possède la symétrie cristalline la plus importante).

On donne ci-après quelques exemples :
(a) les hétérostructures InGaAsP/InAlAsP sur des substrats de InP, pour des diodes lasers émettant aux longueurs d'onde des télécommunications (1,3 µm et 1,55 µm) et compatibles avec la technique relative à InP
(b) les hétérostructures InGaAs/GaAlAs sur des substrats de GaAs, pour des diodes lasers émettant dans le domaine allant de 0,8 µm à 1 µm
(c) les hétérostructures ZnCdSe/ZnSe sur des substrats de GaAs, pour des diodes lasers émettent à 0,5 µm
(d) les hétérostructures de type wurtzite InGaN/AlGaN sur des substrats de saphire, pour des diodes émettant dans le domaine allant de 0,3 µm à 0,4 µm.

On donne maintenant un exemple d'hétérostructure III-V émettant à 1,55 µm. On fait croître cette hétérostructure de façon cohérente sur un substrat de InP(111). Il s'agit d'un exemple correspondant au deuxième mode de réalisation préféré. L'état de contrainte de chacune des couches est défini par rapport aux paramètres cristallins du substrat. La constitution de la zone correspondant aux couches de confinement et à la couche active est la suivante :
couche C₂ de confinement adaptée au réseau, en In_{0,52}Al_{0,48}As, de 300 nm d'épaisseur
couche CQW₁ de puits quantique de collection comprimée, en In_{0,63}Ga_{0,37}As, de 5 nm d'épaisseur
couche PB₁ de barrière piézoélectrique dilatée, en In_{0,42}Al_{0,58}As, de 20 nm d'épaisseur
couche AQW de puits quantique actif comprimée, en In_{0,63}Ga_{0,37}As, de 15 nm d'épaisseur
couche PB₂ de barrière piézoélectrique dilatée, en In_{0,42}Al_{0,58}As, de 20 nm d'épaisseur
couche CQW₂ de puits quantique de collection comprimée, en In_{0,63}Ga_{0,37}As, de 5 nm d'épaisseur
couche C₃ de confinement adaptée au réseau, en In_{0,52}Al_{0,48}As, de 300 nm d'épaisseur.

On donne maintenant un exemple d'hétérostructure II-VI correspondant au troisième mode de réalisation préféré de l'invention :

| | |
|---|---|
| (211) Cd_{0,96}Zn_{0,04}Te | substrat |
| 2 µm de Cd_{0,78}Mg_{0,22}Te | couche-tampon |
| 200 nm de Cd_{0,50}Mg_{0,50}Te | première couche de confinement inférieure |
| 300 nm de Cd_{0,70}Mg_{0,30}Te | deuxième couche de confinement inférieure C₂ |
| 7 nm de Cd_{0,85}Mg_{0,15}Te | CQW₁₁ |
| 5 nm de Cd_{0,62}Zn_{0,08}Mg_{0,30}Te | PB₁₁ |
| 7 nm de Cd_{0,92}Mg_{0,08}Te | CQW₁₂ |
| 5 nm de Cd_{0,62}Zn_{0,08}Mg_{0,30}Te | PB₁₂ |
| 15 nm de CdTe | AQW |
| 5 nm de Cd_{0,62}Zn_{0,08}Mg_{0,30}Te | PB₂₁ |
| 7 nm de Cd_{0,92}Mg_{0,08}Te | CQW₂₁ |
| 5 nm de Cd_{0,62}Zn_{0,08}Mg_{0,30}Te | PB₂₂ |
| 7 nm de Cd_{0,85}Mg_{0,15}Te | CQW₂₂ |
| 300 nm de Cd_{0,70}Mg_{0,30}Te | première couche de confinement supérieure C₃ |
| 200 nm de Cd_{0,50}Mg_{0,50}Te | deuxième couche de confinement supérieure |
| 5 nm CdTe | couche de couverture |

Dans les deux exemples que l'on vient de donner les dopages respectifs des couches et du substrat sont choisis de façon à former une jonction P-I-N.

On précise que l'on a réalisé un premier échantillon de l'hétérostructure II-VI mentionnée ci-dessus, pour démontrer le principe de modulation de la longueur d'onde de l'émission laser. Pour éviter une manipulation « lourde » de l'échantillon on a choisi de ne pas pomper électriquement, mais optiquement. On a clivé l'échantillon afin de former une cavité en forme de barreau, délimitée par deux faces parallèles.

On a réalisé une expérience de pompage optique pour obtenir l'émission d'un rayonnement laser et la charge de l'hétérostructure, au moyen d'un laser pulsé Nd:YAG 532 nm. En travaillant à la température de 80K on a tracé des spectres d'émission par la tranche (« edge emission ») pour ce barreau en deçà et au-delà du seuil laser.

En augmentant la puissance de pompage optique au-dessus de ce seuil, de 6 à 30 kW/cm², on a observé un décalage de l'ordre de 3 à 4 nm vers les grandes longueurs d'onde pour la longueur d'onde du rayonnement laser dans le domaine spectral centré sur 800 nm.

L'invention permet de réaliser d'autres dispositifs que des diodes lasers : on peut réaliser des amplificateurs de lumière qui ne comprennent donc pas de cavité laser.

De plus, on peut réaliser un laser « tout optique » conforme à l'invention. Alors la jonction P-I-N n'est pas nécessaire. Il suffit alors d'utiliser l'hétérostructure avec sa zone active. Le gain et la modulation de longueur d'onde sont alors obtenus au moyen d'un ou d'une pluralité de faisceaux lasers. Dans un mode de réalisation, un laser accordable est prévu comprenant une hétérostructure semiconductrice, l'hétérostructure comprenant une zone active comprenant au moins un puits quantique (AQW) appelé puits quantique actif et destiné à émettre un rayonnement laser lors de l'introduction de porteurs de charge dans la zone active et au moins un autre puits quantique (CQW1, CQW2; CQW11-CQW12, CQW21-CQW22), appelé puits quantique de collection, de chaque côté du puits quantique actif, les puits quantiques de collection étant prévus pour collecter et confiner une partie des porteurs de charge introduits, et des moyens de répartition des porteurs de charge dans les puits quantiques de collection de manière à créer un champ de charge d'espace prévu pour agir sur le puits quantique actif pendant l'émission du rayonnement laser en modifiant, par un effet électro-optique, le spectre de gain de ce puits quantique actif.

Par exemple, la transition optique la plus basse de chacun des puits quantiques de collection est à une énergie supérieure à celle du puits quantique actif (AQW).

Dans un mode de réalisation, les états fondamentaux des bandes de valence et de conduction de l'hétérostructure sont dans le puits quantique actif (AQW).

Dans un mode de réalisation, le laser forme une diode laser, l'hétérostructure forme une jonction P-I-N destinée à être polarisée de façon directe et comportant une zone intrinsèque comprise entre une zone de type P et une zone de type N, la zone active étant formée dans cette zone intrinsèque, le rayonnement laser étant émis lors de l'injection d'un courant des porteurs de charge dans la zone active.

Dans un mode de réalisation, les moyens de répartition des porteurs de charge comprennent des moyens de polarisation directe de la jonction P-I-N, l'inhomogénéité du courant d'injection dans la zone active étant responsable de la séparation des porteurs de charge.

Dans un mode de réalisation, les moyens de répartition des porteurs de charges comprennent deux barrières piézoélectriques (PB1, PB2) qui sont respectivement placées de part et d'autre du puits quantique actif (AQW) et qui, par l'intermédiaire de leurs champs piézoélectriques, provoquent une accumulation d'électrons et de trous de part et d'autre du puits quantique actif.

Par exemple, le puits quantique actif (AQW) n'a pas de champ piézoélectrique ou a un champ piézoélectrique de sens contraire à celui qui est créé par les barrières piézoélectriques.

Dans un mode de réalisation, le puits quantique actif (AQW) a un champ piézoélectrique de même sens que celui qui est créé par les barrières piézoélectriques.

Dans un mode de réalisation, les puits quantiques de collection sont conçus pour que les temps mis par les porteurs de charge pour s'échapper de ces puits quantiques de collection soient de l'ordre de 1 nanoseconde.

Selon un mode de réalisation, la zone active comprend au moins deux barrières piézoélectriques (PB11-PB12, PB21-PB22) et au moins deux puits quantiques de collection (CQW11-CQW12, CQW21-CQW22) de chaque côté du puits quantique actif, les moyens de répartition des porteurs de charge comprenant ces barrières piézoélectriques.

Par exemple, la largeur de bande interdite de chacun des puits quantiques de collection (CQW22, CQW11), qui sont les plus loins du puits quantique actif, est supérieure à celle de chacun des autres puits quantiques de collection (CQW12, CQW21).

Dans un mode de réalisation, le nombre de porteurs de charge introduits est constant et la longueur d'onde du rayonnement laser est commandée par un faisceau laser auxiliaire dont les photons ont une énergie supérieure à la largeur de bande interdite de chaque barrière piézoélectrique et dont l'intensité est suffisamment élevée pour induire optiquement une charge de l'hétérostructure.

Par exemple, les porteurs de charge sont introduits au moyen d'un faisceau laser prévu pour pomper la zone active.

Dans un mode de réalisation, le faisceau laser prévu pour pomper la zone active est également prévu pour constituer le faisceau laser auxiliaire.

Selon un mode de réalisation, l'hétérostructure est faite de matériaux semiconducteurs cristallins III-V ou II-VI dont les structures cristallines sont de type zincblende ou wurtzite.

Dans un ourtre mode de réalisation, l'hétérostructure est faite de matériaux semiconducteurs cristallins III-V ou II-VI dont les structures cristallines sont de type zincblende et cette hétérostructure est formée sur une couche semiconductrice dont les indices cristallographiques (n, 1, m) sont élevés, nxlxm étant différent de 0.

Dans un mode de réalisation, l'hétérostructure est faite de matériaux semiconducteurs cristallins III-V ou II-VI dont les structures cristallines sont de type wurtzite et cette hétérostructure est formée suivant l'axe c du réseau cristallin de l'hétérostructure.

Par exemple, ledit effet électro-optique est l'effet Stark confiné quantique.

Les documents cités dans la présente description sont les suivants :
[1] N.K. Dutta, W.S. Hobson, J. Lopata, G. Zydzik, Appl. Phys. Lett. 70, 1219 (1997)
[2] F. Favre, D. Le Guen, J.C. Simon, B. Landousies, Electron. Lett. 22, 795 (1986)
[3] S. Murata, I. Mito, Optical and Quantum Electronics 22, 1 (1990)
[4] L.Y. Liu, E.E. Mendez, H. Meier, Appl. Phys. Lett. 60, 2971 (1992)
[5] E. Anastassakis, Phys. Rev. B 46 4744 (1992)
[6] R. André, C. Deshayes, J. Cibert, L.S. Dang, S. Tatarenko, K. Saminadayar, Phys. Rev. B 42, 11392 (1990)
[7] N.T. Pelekanos, EP 0681200 A et US 5698863 A
[8] V. Ortiz, N.T. Pelekanos, G. Mula, Appl. Phys. Lett. 72, 963 (1998).

## Revendications

1. Laser accordable comprenant une hétérostructure semiconductrice, ce laser étant **caractérisé en ce que** l'hétérostructure comprend une zone active comprenant au moins un puits quantique (AQW) appelé puits quantique actif et destiné à émettre un rayonnement laser lors de l'introduction de porteurs de charge dans la zone active et au moins un autre puits quantique (CQW1, CQW2; CQW11-CQW12, CQW21-CQW22), appelé puits quantique de collection, de chaque côté du puits quantique actif, les puits quantiques de collection étant prévus pour collecter et confiner une partie des porteurs de charge introduits.

2. Laser selon la revendication 1, dans lequel la transition optique la plus basse de chacun des puits quantiques de collection est à une énergie supérieure à celle du puits quantique actif (AQW).

3. Laser selon l'une quelconque des revendications 1 et 2, dans lequel les états fondamentaux des bandes de valence et de conduction de l'hétérostructure sont dans le puits quantique actif (AQW).

4. Laser selon l'une quelconque des revendications 1 à 3, ce laser formant une diode laser, l'hétérostructure formant une jonction P-I-N destinée à être polarisée de façon directe et comportant une zone intrinsèque comprise entre une zone de type P et une zone de type N, la zone active étant formée dans cette zone intrinsèque, le rayonnement laser étant émis lors de l'injection d'un courant des porteurs de charge dans la zone active.

5. Laser selon l'une quelconque des revendications 1 à 4, dans lequel la zone active comprend au moins deux barrières piézoélectriques (PB11-PB12, PB21-PB22) et au moins deux puits quantiques de collection (CQW11-CQW12, CQW21-CQW22) de chaque côté du puits quantique actif, des moyens de répartition des porteurs de charge comprenant ces barrières piézoélectriques.

6. Laser selon la revendication 5, dans lequel la largeur de bande interdite de chacun des puits quantiques de collection (CQW22, CQW11), qui sont les plus loins du puits quantique actif, est supérieure à celle de chacun des autres puits quantiques de collection (CQW12, CQW21).

7. Laser selon l'une quelconque des revendications 1 à 6, dans lequel l'hétérostructure est faite de matériaux semiconducteurs cristallins III-V ou II-VI dont les structures cristallines sont de type zincblende ou wurtzite.

8. Laser selon l'une quelconque des revendications 1 à 6, dans lequel l'hétérostructure est faite de matériaux semiconducteurs cristallins III-V ou II-VI dont les structures cristallines sont de type zincblende et cette hétérostructure est formée sur une couche semiconductrice dont les indices cristallographiques (n, l, m) sont élevés, nxlxm étant différent de 0.

9. Laser selon l'une quelconque des revendications 1 à 6, dans lequel l'hétérostructure est faite de matériaux semiconducteurs cristallins III-V ou II-VI dont les structures cristallines sont de type wurtzite et cette hétérostructure est formée suivant l'axe c du réseau cristallin de l'hétérostructure.

10. Laser selon l'une quelconque des revendications 1 à 9, dans lequel les puits quantiques de collection sont peu profonds et dans lequel les barrières piézoélectriques entourant le puits quantique actif sont fines.
